# EUROPEAN PATENT APPLICATION

(11) **EP 3 343 585 A1**
(43) Date of publication of application: **04.07.2018**
(21) Application number: 17210960.5
(22) Date of filing: 28.12.2017
(51) Int. Cl.: H01H 47/00, H01H 47/22, H01H 50/64

(54) **RELAY CONTROL CIRCUIT**

(30) Priority: 31.12.2016 CN 201621495020 U
(71) Applicant: Optimum Battery Co., Ltd., Shenzhen City, Guangdong 518118 (CN)
(72) Inventor: DENG, Hong, Shenzhen, Guangdong 518118 (CN)
(74) Representative: Greaves Brewster LLP

(57) **Abstract**

A relay control circuit includes a relay module, a drive module, and a control module. The relay module comprises a plurality of relays and an auxiliary diagnostic unit electrically coupled to the relays. The drive module comprises a drive chip electrically coupled to the relays. The control module comprises a control unit electrically coupled to the drive chip and the auxiliary diagnostic unit. Each of the drive chip and the auxiliary diagnostic unit detects an operating state of each relay, and outputs the operating state of each relay to the control unit. When the operating state of each relay detected by the drive chip or the operating state of each relay detected by the auxiliary diagnostic unit indicates any relay fails, the control unit controls the drive chip to stop operating, and each relay is turned off.

## Description

### BACKGROUND OF THE INVENTION

### Field of the Invention

This invention relates to electric vehicles, and more particular, to a relay control circuit applied in an electric vehicle.

### Description of the Related Art

Generally, electric vehicles are powered by battery packs, and each electric vehicle uses a plurality of relays, to open and close a circuit of a corresponding battery pack to power each electric vehicle. However, if one of the relays of an electric vehicle fails, the electric vehicle cannot detect failure of the relay, and the failure of the relay cannot be processed in time, it will bring great safety hazard to the electric vehicle.

It is desirable to provide an invention, which can overcome the problems and limitations mentioned above.

### SUMMARY OF THE INVENTION

The present invention is directed to a relay control circuit that substantially obviates one or more of the problems due to limitations and disadvantages of the related art.

In an aspect of the present invention, there is provided a relay control circuit comprising a relay module, a drive module, and a control module. The relay module comprises a plurality of relays and an auxiliary diagnostic unit electrically coupled to the relays. The drive module comprises a drive chip electrically coupled to the relays. The control module comprises a serial peripheral interface (SPI) and a control unit electrically coupled to the auxiliary diagnostic unit, and electrically coupled to the drive chip through the SPI. The drive chip is configured to detect an operating state of each relay, and output the operating state of each relay detected by the drive chip to the control unit. The auxiliary diagnostic unit is configured to detect the operating state of each relay, and output the operating state of each relay detected by the auxiliary diagnostic unit to the control unit. On condition that the operating state of each relay detected by the drive chip and the operating state of each relay detected by the auxiliary diagnostic unit indicate each relay operates properly, the control unit outputs control signals to the drive chip through the SPI, and the drive chip controls each relay to be turned on or turned off, according to the control signals. On condition that the operating state of each relay detected by the drive chip or the operating state of each relay detected by the auxiliary diagnostic unit indicates any relay fails, the control unit controls the drive chip to stop operating, and each relay is turned off.

It is to be understood that both the foregoing general description and the following detailed description are exemplary and explanatory and are intended to provide further explanations of the invention as claimed.

### BRIEF DESCRIPTION OF THE DRAWINGS

Implementations of the present technology will now be described, by way of example only, with reference to the attached drawings. It may be understood that these drawings are not necessarily drawn to scale, and in no way limit any changes in form and detail that may be made to the described embodiments by one skilled in the art without departing from the SPI 16rit and scope of the described embodiments.
FIG. 1 is a block schematic diagram of a relay control circuit provided by one embodiment of the present invention, wherein the relay control circuit comprises a control module, a drive module, and a relay module, and the drive module comprises a signal transmission unit and a drive chip.

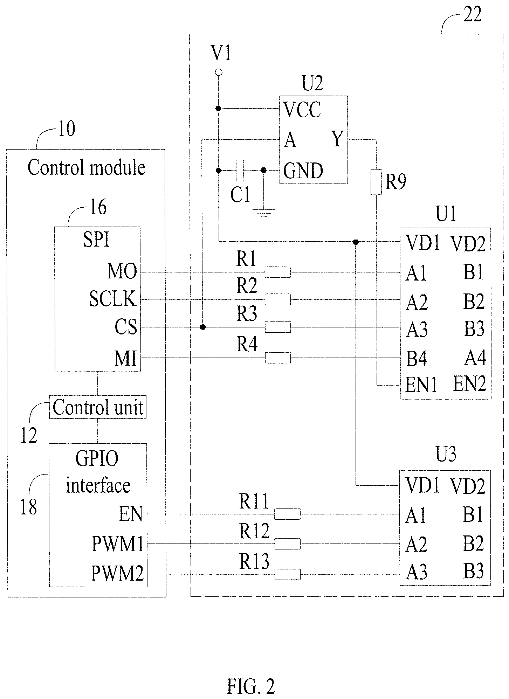

FIG. 2 is a circuit diagram of the control module electrically coupled to the signal transmission unit of FIG. 1.
FIG. 3 is a circuit diagram of the drive chip electrically coupled to the signal transmission unit and the relay module of FIG. 1.

### DETAILED DESCRIPTION OF THE PREFERRED EMBODIMENTS

In order to make the purposes, technical solutions, and advantages of the present invention be clearer, the present invention will be further described in detail hereafter with reference to the accompanying drawings and embodiments. However, it will be understood by those of ordinary skill in the art that the embodiments described herein can be practiced without these specific details. In other instances, methods, procedures and components have not been described in detail so as not to obscure the related relevant feature being described. Also, it should be understood that the embodiments described herein are only intended to illustrate but not to limit the present invention.

Several definitions that apply throughout this disclosure will be presented. The term "coupled" is defined as connected, whether directly or indirectly through intervening components, and is not necessarily limited to physical connections. The connection can be such that the objects are permanently connected or releasably connected. The term "comprise", when utilized, means "include, but not necessarily limited to"; it specifically indicates open-ended inclusion or membership in a so-described combination, group, series and the like.

It should be noted that references to "an" or "one" embodiment in this disclosure are not necessarily to the same embodiment, and such references mean "at least one."

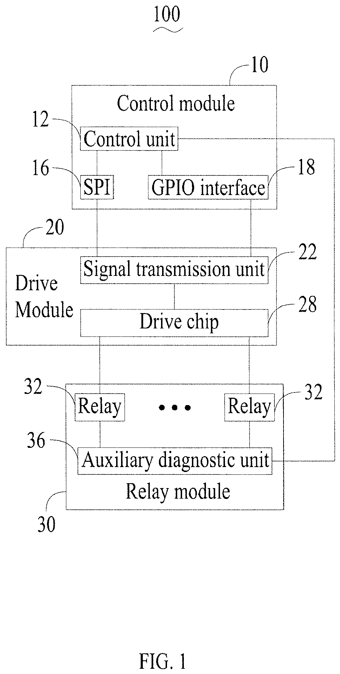

Fig. 1 illustrates a block schematic diagram of a relay control circuit 100 provided by one embodiment of the present invention. The relay control circuit 100 comprises a control module 10, a drive module 20, and a relay module 30. The control module 10 comprises a control unit 12 and a serial peripheral interface (SPI) 16. The drive module 20 comprises a drive chip 28. The relay module 30 comprises a plurality of relays 32 and an auxiliary diagnostic unit 36 electrically coupled to the relays 32. The control unit 12 is electrically coupled to the auxiliary diagnostic unit 36, and electrically coupled to the drive chip 28 through the SPI 16. Each relay 32 is electrically coupled to the drive chip 28.

The drive chip 28 is configured to detect an operating state of each relay 32, and output the operating state of each relay 32 detected by the drive chip 28 to the control unit 12. The auxiliary diagnostic unit 36 is configured to detect the operating state of each relay 32, and output the operating state of each relay 32 detected by the auxiliary diagnostic unit 36 to the control unit 12. When the operating state of each relay 32 detected by the drive chip 28 and the operating state of each relay 32 detected by the auxiliary diagnostic unit 36 indicate each relay 32 operates properly, the control unit 12 outputs control signals to the drive chip 28 through the SPI 16, and the drive chip 28 controls each relay 32 to be turned on or turned off, according to the control signals. When the operating state of each relay 32 detected by the drive chip 28 or the operating state of each relay 32 detected by the auxiliary diagnostic unit 36 indicates any relay 32 fails, the control unit 12 controls the drive chip 28 to stop operating, and each relay 32 is turned off. It may be understood that, if a relay 32 is short-circuited or open-circuited, each of the drive chip 28 and the auxiliary diagnostic unit 36 will detect that the relay 32 fails, and output an operating state signal indicating that the relay 32 fails, to the control unit 12.

In one embodiment, the control unit 12 is configured to transmit a self-test signal to the drive chip 28 through the SPI 16, to control the drive chip 28 to perform self-test. When the self-test is passed, the drive chip 28 detects the operating state of each relay 32, and outputs a pass signal indicating the self-test passed and the operating state of each relay 32 to the control unit 12. When the self-test is failed, the drive chip 28 outputs a fail signal indicating the self-test failed to the control unit 12, and the control unit 12 controls the drive chip 28 to stop operating.

In one embodiment, the drive module 20 further comprises a signal transmission unit 22 configured to electrically isolate signals transmitted by the signal transmission unit 22. The SPI 16 is electrically coupled to the drive chip 28 through the signal transmission unit 22.

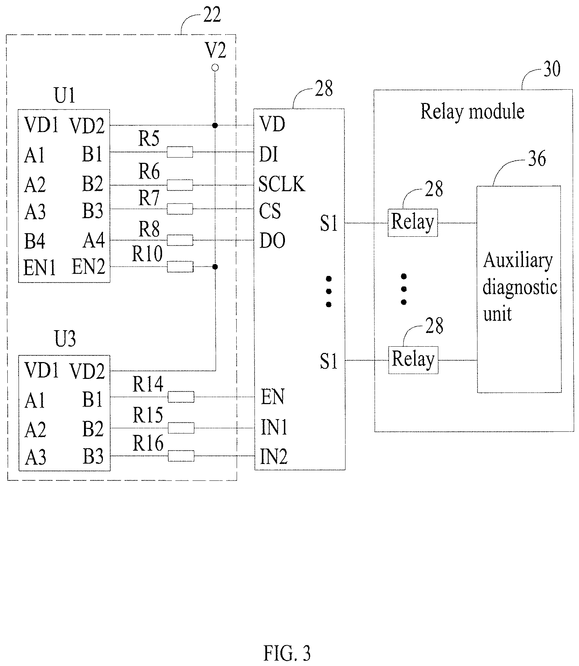

Please refer to Figs. 1 and 3, the signal transmission unit 22 comprises a first isolation chip U1 electrically coupled to the SPI 16 and the drive chip 28. The first isolation chip U1 comprises first to fourth input pins A1-A4 and first to fourth output pins B1-B4. The SPI 16 comprises a data output pin MO, a clock signal pin SCLK, a chip select signal pin CS, and a data input pin MI. The data output pin MO of the SPI 16 is electrically coupled to the first input pin A1 of the first isolation chip U1. The clock signal pin SCLK of the SPI 16 is electrically coupled to the second input pin A2 of the first isolation chip U1. The chip select signal pin CS electrically coupled to the third input pin A3 of the first isolation chip U1. The data input pin MI of the SPI 16 is electrically coupled to the fourth output pin B4 of the first isolation chip U1.

The drive chip 28 comprises a data input pin DI, a clock signal pin SCLK, a chip select signal pin CS, a data output pin DO, and a plurality of signal transmission pins S1. The data input pin DI of the drive chip 28 is electrically coupled to the first output pin B1 of the first isolation chip U1. The clock signal pin SCLK of the drive chip 28 is electrically coupled to the second output pin B2 of the first isolation chip U1. The chip select signal pin CS of the drive chip 28 is electrically coupled to the third output pin B3 of the first isolation chip U1. The data output pin DO of the drive chip 28 is electrically coupled to the fourth input pin A4 of the first isolation chip U1. Each signal transmission pin S1 of the drive chip 28 is electrically coupled to a corresponding relay 32 of the relay module 30.

The self-test signal and the control signals output from the control unit 12 are transmitted to the data input pin DI of the drive chip 28 through the data output pin MO of the SPI 16, and the first input pin A1 and the first output pin B1 of the first isolation chip U1. A clock signal output from the control unit 12 is transmitted to the clock signal pin SCLK of the drive chip 28 through the clock signal pin SCLK of the SPI 16, and the second input pin A2 and the second output pin B2 of the first isolation chip U1. A chip select signal output from the control unit 12 is transmitted to the chip select signal pin CS of the drive chip 28 through the chip select signal pin CS of the SPI 16 and the third input pin A3 and the third output pin B3 of the first isolation chip U1. The operating state of each relay 32, the pass signal, and the fail signal output from the data output pin DO of the drive chip 28 are transmitted to the control unit 12 through the fourth input pin A4 and the fourth output pin B4 of the first isolation chip U1, and the data input pin MI of the SPI 16.

In one embodiment, the signal transmission unit 22 further comprises first to eighth resistors R1-R8. The first input pin A1 of the first isolation chip U1 is electrically coupled to the data output pin MO of the SPI 16 through the first resistor R1. The second input pin A2 of the first isolation chip U1 is electrically coupled to the clock signal pin SCLK of the SPI 16 through the second resistor R2. The third input pin A3 of the first isolation chip U1 is electrically coupled to the chip select signal pin CS of the SPI 16 through the third resistor R3. The fourth output pin B4 of the first isolation chip U1 is electrically coupled to the data input pin MI of the SPI 16 through the fourth resistor R4. The first output pin B1 of the first isolation chip U1 is electrically coupled to the data input pin DI of the drive chip 28 through the fifth resistor R5. The second output pin B2 of the first isolation chip U1 is electrically coupled to the clock signal pin SCLK of the drive chip 28 through the sixth resistor R6. The third output pin B3 of the first isolation chip U1 is electrically coupled to the chip select signal pin CS of the drive chip 28 through the seventh resistor R7. The fourth input pin A4 of the first isolation chip U1 is electrically coupled to the data output pin DO of the drive chip 28 through the eighth resistor R8.

In one embodiment, the first isolation chip U1 further comprises a first enable pin EN1. The signal transmission unit 22 further comprises a level shifter U2 electrically coupled to the chip select signal pin CS of the SPI 16 and the first enable pin EN1 of the first isolation chip U1. The level shifter U2 is configured to receive a chip select signal from the chip select signal pin CS of the SPI 16, convert a logic level of the chip select signal to generate an enable signal, and output the enable signal to the first enable pin EN1 of the first isolation chip U1.

When the chip select signal is at a high level (such as, logic 1), the level shifter U2 output the enable signal at a low level (such as, logic 0) to the first enable pin EN1 of the first isolation chip U1, and the first isolation chip U1 does not operate. When the chip select signal is at a low level (such as, logic 0), the level shifter U2 output the enable signal at a high level (such as, logic 1) to the first enable pin EN1 of the first isolation chip U1, and the first isolation chip U1 operates. In one embodiment, the chip selection signal is active at a low level (such as, logic 0), and when the first enable pin EN1 of the first isolation chip U1 receive a high level signal, the first isolation chip U1 starts to operate. The level shifter U2 coverts the chip select signal output from the chip select signal pin CS of the SPI 16 into the enable signal. When the chip select signal is valid, the enable signal is valid; and when the chip select signal is invalid, the enable signal is invalid.

In one embodiment, the level shifter U2 comprises a power pin VCC, an input pin A, an output pin Y, and a ground pin GND. The power pin VCC of the level shifter U2 is electrically coupled to a first power supply VI, and electrically coupled to ground through a capacitor C1. The input pin A of the level shifter U2 is electrically coupled to the chip select signal pin CS of the SPI 16 to receive the chip select signal. The output pin Y of the level shifter U2 is electrically coupled to the first enable pin EN1 of the first isolation chip U1 through a ninth resistor R9, to output the enable signal to the first isolation chip U1. The ground pin GND of the level shifter U2 is electrically coupled to ground.

In one embodiment, the first isolation chip U1 further comprises a first power pin VD1, a second power pin VD2, and a second enable power pin EN2. The first power pin VD1 of the first isolation chip U1 is electrically coupled to the first power supply V1. The second power pin VD2 of the first isolation chip U1 is electrically coupled to a second power supply V2. The second enable power pin EN2 of the first isolation chip U1 is electrically coupled to the second power supply V2 through a tenth resistor R10.

In one embodiment, the control module 10 further comprises a general purpose input output (GPIO) interface. The control unit 12 is electrically coupled to the drive chip 28 through the GPIO interface 18, and transmits signals to the drive chip 28 through the GPIO interface 18, to control an operation mode of the drive chip 28 .

In one embodiment, the signal transmission unit 22 further comprises a second isolation chip U3 electrically coupled to the GPIO interface 18 and the drive chip 28. The second isolation chip U3 comprises first to third input pins A1-A3, first to third output pins B1-B3, a first power pin VD1 electrically coupled to the first power supply VI, and a second power pin VD2 electrically coupled to the second power supply V2.

The GPIO interface 18 comprises an enable pin EN, a first pulse width modulation pin PWM1, and a second pulse width modulation pin PWM2. The enable pin EN of the GPIO interface 18 is electrically coupled to the first input pin A1 of the second isolation chip U3. The first pulse width modulation pin PWM1 of the GPIO interface 18 is electrically coupled to the second input pin A2 of the second isolation chip U3. The second pulse width modulation pin PWM2 of the GPIO interface 18 is electrically coupled to the third input pin A3 of the second isolation chip U3.

The drive chip 28 further comprises an enable pin EN, a first input pin IN1, and a second input pin IN2. The enable pin EN of the drive chip 28 is electrically coupled to the first output pin B1 of the second isolation chip U3. The first input pin IN1 of the drive chip 28 is electrically coupled to the second output pin B2 of the second isolation chip U3. The second input pin IN2 of the drive chip 28 is electrically coupled to the third output pin B3 of the second isolation chip U3.

In one embodiment, an enable signal output from the control unit 12 is transmitted to the enable pin EN of the drive chip 28 through the enable pin EN of the GPIO interface 18 and the first input pin A1 and the first output pin B1 of the second isolation chip U3. A first pulse width modulation signal output from the control unit 12 is transmitted to the first input pin IN1 of the drive chip 28 through the first pulse width modulation pin PWM1 of the GPIO interface 18 and the second input pin A2 and the second output pin B2 of the second isolation chip U3. A second pulse width modulation signal output from the control unit 12 is transmitted to the second input pin IN2 of the drive chip 28 through the second pulse width modulation pin PWM2 of the GPIO interface 18 and the third input pin A3 and the third output pin B3 of the second isolation chip U3. The drive chip 28 operates in a corresponding operation mode, according to the enable signal, the first pulse width modulation signal, and the second pulse width modulation signal received from the control unit 12.

In one embodiment, the signal transmission unit 22 further comprises eleventh to sixteenth resistors R11-R16. The first input pin A1 of the second isolation chip U3 is electrically coupled to the enable pin EN of the GPIO interface 18 through the eleventh resistor R11. The second input pin A2 of the second isolation chip U3 is electrically coupled to the first pulse width modulation pin PWM1 of the GPIO interface 18 through the twelfth resistor R12. The third input pin A3 of the second isolation chip U3 is electrically coupled to the second pulse width modulation pin PWM2 of the GPIO interface 18 through the thirteenth resistor R13. The first output pin B1 of the second isolation chip U3 is electrically coupled to the enable pin EN of the drive chip 28 through the fourteenth resistor R14. The second output pin B2 of the second isolation chip U3 is electrically coupled to the first input pin IN1 of the drive chip 28 through the fifteenth resistor R15. The third output pin B3 of the second isolation chip U3 is electrically coupled to the second input pin IN2 of the drive chip 28 through the sixteenth resistor R16.

In one embodiment, the control unit 12 comprises at least one of a central processing unit, a network processor, a digital signal processor, an application specific integrated circuit, a field-programmable gate array, and a micro control unit.

An operation principle of the relay control circuit 100 provided by one embodiment of the present invention will be described below.

When the relay control circuit 100 is powered on, the control unit 12 transmits the self-test signal, the clock signal, and the chip select signal to the drive chip 28 through the SPI 16, and transmits the enable signal, the first pulse width modulation signal, and the second pulse width modulation to the drive chip 28 through the GPIO interface 18. When the chip select signal and the enable signal received by the drive chip 28 are valid, the drive chip 28 starts to operate and performs self-test.

When the self-test is failed, the drive chip 28 outputs the fail signal indicating the self-test failed to the control unit 12, and the control unit 12 controls the drive chip 28 to stop operating. When the self-test is passed, the drive chip 28 detects the operating state of each relay 32, and outputs the pass signal indicating the self-test passed and the operating state of each relay 32 detected by the drive chip 28 to the control unit 12. When the operating state of each relay 32 detected by the drive chip 28 indicates any relay 32 fails, the control unit 12 controls the drive chip 28 to stop operating, and each relay 32 is turned off. When the operating state of each relay 32 detected by the drive chip 28 indicates each relay 32 operates properly, the control unit 12 outputs the control signals to the drive chip 28 through the SPI 16, and the drive chip 28 controls each relay 32 to be turned on or turned off, according to the control signals. When each relay 32 operates, the drive chip 28 detects the operating state of each relay 32, and output the operating state of each relay 32 detected by the drive chip 28 to the control unit 12; and the auxiliary diagnostic unit 36 detects the operating state of each relay 32, and output the operating state of each relay 32 detected by the auxiliary diagnostic unit 36 to the control unit 12.

When the operating state of each relay 32 detected by the drive chip 28 and the operating state of each relay 32 detected by the auxiliary diagnostic unit 36 indicate each relay 32 operates properly, the control unit 12 outputs the control signals to the drive chip 28 through the SPI 16, and the drive chip 28 controls each relay 32 to be turned on or turned off, according to the control signals. When the operating state of each relay 32 detected by the drive chip 28 or the operating state of each relay 32 detected by the auxiliary diagnostic unit 36 indicates any relay 32 fails, the control unit 12 controls the drive chip 28 to stop operating, and each relay 32 is turned off.

As detail above, the drive chip 28 drives each relay 32 to operate, detects the operating state of each relay 32, and outputs the operating state of each relay 32 detected by the drive chip 28 to the control unit 12; the auxiliary diagnostic unit 36 detects the operating state of each relay 32, and output the operating state of each relay 32 detected by the auxiliary diagnostic unit 36 to the control unit 12; the control unit 12 determines whether any relay 32 fails, according to the operating state of each relay 32 detected by the drive chip 28 and the operating state of each relay 32 detected by the auxiliary diagnostic unit 36; and when any relay 32 fails, the control unit 12 controls the drive chip 28 to stop operating, and each relay 32 is turned off. Therefore, the relay control circuit 100 can detect failure of each relay 32 and process the failures in time, and safety and reliability of the relay control circuit 100 are improved.

It will be apparent to those skilled in the art that various modification and variations can be made in the multicolor illumination device and related method of the present invention without departing from the SPI 16rit or scope of the invention. Thus, it is intended that the present invention cover modifications and variations that come within the scope of the appended claims and their equivalents.

## Claims

1. A relay control circuit (100), comprising:
a relay module (30) comprising a plurality of relays (32) and an auxiliary diagnostic unit (36) electrically coupled to the relays (32);
a drive module (20) comprising a drive chip (28) electrically coupled to the relays (32); and
a control module (10) comprising a serial peripheral interface (SPI) (16) and a control unit (12) electrically coupled to the auxiliary diagnostic unit (36), and electrically coupled to the drive chip (28) through the SPI (16);
wherein the drive chip (28) is configured to detect an operating state of each relay (32), and output the operating state of each relay (32) detected by the drive chip (28) to the control unit (12); and the auxiliary diagnostic unit (36) is configured to detect the operating state of each relay (32), and output the operating state of each relay (32) detected by the auxiliary diagnostic unit (36) to the control unit (12);
wherein on condition that the operating state of each relay (32) detected by the drive chip (28) and the operating state of each relay (32) detected by the auxiliary diagnostic unit (36) indicate each relay (32) operates properly, the control unit (12) outputs control signals to the drive chip (28) through the SPI (16), and the drive chip (28) controls each relay (32) to be turned on or turned off, according to the control signals; and
wherein on condition that the operating state of each relay (32) detected by the drive chip (28) or the operating state of each relay (32) detected by the auxiliary diagnostic unit (36) indicates any relay (32) fails, the control unit (12) controls the drive chip (28) to stop operating, and each relay (32) is turned off.

2. The relay control circuit (100) of claim 1, wherein the control unit (12) is configured to transmit a self-test signal to the drive chip (28) through the SPI (16), to control the drive chip (28) to perform self-test;
wherein on condition that the self-test is passed, the drive chip (28) detects the operating state of each relay (32), and outputs a pass signal and the operating state of each relay (32) detected by the drive chip (28) to the control unit (12); and
wherein on condition that the self-test is failed, the drive chip (28) outputs a fail signal to the control unit (12), and the control unit (12) controls the drive chip (28) to stop operating.

3. The relay control circuit (100) of claim 2, wherein the drive module (20) further comprises a signal transmission unit (22) configured to electrically isolate signals transmitted by the signal transmission unit (22), the SPI (16) is electrically coupled to the drive chip (28) through the signal transmission unit (22).

4. The relay control circuit (100) of claim 3, wherein the signal transmission unit (22) comprises a first isolation chip (U1) electrically coupled to the SPI (16) and the drive chip (28), and the first isolation chip (U1) comprises first to fourth input pins (A1-A4) and first to fourth output pins (B1-B4).

5. The relay control circuit (100) of claim 4, wherein the SPI (16) comprises:
a data output pin (MO) electrically coupled to the first input pin (A1) of the first isolation chip (U1);
a clock signal pin (SCLK) electrically coupled to the second input pin (A2) of the first isolation chip (U1);
a chip select signal pin (CS) electrically coupled to the third input pin (A3) of the first isolation chip (U1); and
a data input pin (MI) electrically coupled to the fourth output pin (B4) of the first isolation chip (U1).

6. The relay control circuit (100) of claim 5, wherein the drive chip 28 comprises:
a data input pin (DI) electrically coupled to the first output pin (B1) of the first isolation chip (U1);
a clock signal pin (SCLK) electrically coupled to the second output pin (B2) of the first isolation chip (U1);
a chip select signal pin (CS) electrically coupled to the third output pin (B3) of the first isolation chip (U1);
a data output pin (DO) electrically coupled to the fourth input pin (A4) of the first isolation chip (U1); and
a plurality of signal transmission pins (S1); and
wherein each signal transmission pin (S1) is electrically coupled to a corresponding relay (32).

7. The relay control circuit (100) of claim 6, wherein the self-test signal and the control signals output from the control unit (12) are transmitted to the data input pin (DI) of the drive chip (28) through the data output pin (MO) of the SPI (16), and the first input pin (A1) and the first output pin (B1) of the first isolation chip (U1); a clock signal output from the control unit (12) is transmitted to the clock signal pin (SCLK) of the drive chip (28) through the clock signal pin (SCLK) of the SPI (16), and the second input pin (A2) and the second output pin (B2) of the first isolation chip (U1); a chip select signal output from the control unit (12) is transmitted to the chip select signal pin (CS) of the drive chip (28) through the chip select signal pin (CS) of the SPI (16) and the third input pin (A3) and the third output pin (B3) of the first isolation chip (U1); the operating state of each relay (32), the pass signal, and the fail signal output from the data output pin (DO) of the drive chip (28) are transmitted to the control unit (12) through the fourth input pin (A4) and the fourth output pin (B4) of the first isolation chip (U1), and the data input pin (MI) of the SPI (16).

8. The relay control circuit (100) of claim 6, wherein the signal transmission unit (22) further comprises first to eighth resistors (R1-R8); the first input pin (A1) of the first isolation chip (U1) is electrically coupled to the data output pin (MO) of the SPI (16) through the first resistor (R1); the second input pin (A2) of the first isolation chip (U1) is electrically coupled to the clock signal pin (SCLK) of the SPI (16) through the second resistor (R2); the third input pin (A3) of the first isolation chip (U1) is electrically coupled to the chip select signal pin (CS) of the SPI (16) through the third resistor (R3); the fourth output pin (B4) of the first isolation chip (U1) is electrically coupled to the data input pin (MI) of the SPI (16) through the fourth resistor (R4); the first output pin (B1) of the first isolation chip (U1) is electrically coupled to the data input pin (DI) of the drive chip (28) through the fifth resistor (R5); the second output pin (B2) of the first isolation chip (U1) is electrically coupled to the clock signal pin (SCLK) of the drive chip (28) through the sixth resistor (R6); the third output pin (B3) of the first isolation chip (U1) is electrically coupled to the chip select signal pin (CS) of the drive chip (28) through the seventh resistor (R7); and the fourth input pin (A4) of the first isolation chip (U1) is electrically coupled to the data output pin (DO) of the drive chip (28) through the eighth resistor (R8).

9. The relay control circuit (100) of claim 5, wherein the first isolation chip (U1) further comprises a first enable pin (EN1); the signal transmission unit (22) further comprises a level shifter (U2) electrically coupled to the chip select signal pin (CS) of the SPI (16) and the first enable pin (EN1) of the first isolation chip (U1); and the level shifter (U2) is configured to receive a chip select signal from the chip select signal pin (CS) of the SPI (16), convert a logic level of the chip select signal to generate an enable signal, and output the enable signal to the first enable pin (EN1) of the first isolation chip (U1).

10. The relay control circuit (100) of claim 9, wherein on condition that the chip select signal is at a high level, the level shifter (U2) output the enable signal at a low level to the first enable pin (EN1) of the first isolation chip (U1), and the first isolation chip (U1) does not operate; and on condition that the chip select signal is at a low level, the level shifter (U2) output the enable signal at a high level to the first enable pin (EN1) of the first isolation chip (U1), and the first isolation chip (U1) operates.

11. The relay control circuit (100) of claim 9, wherein the level shifter (U2) comprises:
a power pin (VCC) electrically coupled to a first power supply (VI), and electrically coupled to ground through a capacitor (C1);
an input pin (A) electrically coupled to the chip select signal pin (CS) of the SPI (16) to receive the chip select signal;
an output pin (Y) electrically coupled to the first enable pin (EN1) of the first isolation chip (U1) through a ninth resistor (R9), to output the enable signal to the first isolation chip (U1); and
a ground pin (GND) electrically coupled to ground.

12. The relay control circuit (100) of claim 4, wherein the first isolation chip (U1) further comprises:
a first power pin (VD1) electrically coupled to a first power supply (VI);
a second power pin (VD2) electrically coupled to a second power supply (V2); and
a second enable power pin (EN2) electrically coupled to the second power supply (V2) through a tenth resistor (R10).

13. The relay control circuit (100) of claim 1, wherein the control module (10) further comprises a general purpose input output (GPIO) interface (18); the control unit (12) is electrically coupled to the drive chip (28) through the GPIO interface (18), and transmits signals to the drive chip (28) through the GPIO interface (18), to control an operation mode of the drive chip (28).

14. The relay control circuit (100) of claim 13, wherein the drive module (20) further comprises a signal transmission unit (22) configured to electrically isolate signals transmitted by the signal transmission unit (22), the GPIO interface (18) is electrically coupled to the drive chip (28) through the signal transmission unit (22).

15. The relay control circuit (100) of claim 14, wherein the signal transmission unit (22) comprises a second isolation chip (U3) electrically coupled to the GPIO interface (18) and the drive chip (28), and the second isolation chip (U3) comprises first to third input pins (A1-A3), first to third output pins (B1-B3), a first power pin (VD1) electrically coupled to a first power supply (VI), and a second power pin (VD2) electrically coupled to a second power supply (V2).

16. The relay control circuit (100) of claim 15, wherein the GPIO interface (18) comprises:
an enable pin (EN) electrically coupled to the first input pin (A1) of the second isolation chip (U3);
a first pulse width modulation pin (PWM1) electrically coupled to the second input pin (A2) of the second isolation chip (U3); and
a second pulse width modulation pin (PWM2) electrically coupled to the third input pin (A3) of the second isolation chip (U3).

17. The relay control circuit (100) of claim 16, wherein the drive chip (28) comprises:
an enable pin (EN) electrically coupled to the first output pin (B1) of the second isolation chip (U3);
a first input pin (IN1) electrically coupled to the second output pin (B2) of the second isolation chip (U3); and
a second input pin (IN2) electrically coupled to the third output pin (B3) of the second isolation chip (U3).

18. The relay control circuit (100) of claim 17, wherein an enable signal output from the control unit (12) is transmitted to the enable pin (EN) of the drive chip (28) through the enable pin (EN) of the GPIO interface (18) and the first input pin (A1) and the first output pin (B1) of the second isolation chip (U3); a first pulse width modulation signal output from the control unit (12) is transmitted to the first input pin (IN1) of the drive chip (28) through the first pulse width modulation pin (PWM1) of the GPIO interface (18) and the second input pin (A2) and the second output pin (B2) of the second isolation chip (U3); a second pulse width modulation signal output from the control unit (12) is transmitted to the second input pin (IN2) of the drive chip (28) through the second pulse width modulation pin (PWM2) of the GPIO interface (18) and the third input pin (A3) and the third output pin (B3) of the second isolation chip (U3); and
wherein the drive chip (28) operates in a corresponding operation mode, according to the enable signal, the first pulse width modulation signal, and the second pulse width modulation signal received from the control unit (12).

19. The relay control circuit (100) of claim 17, wherein the signal transmission unit (22) further comprises eleventh to sixteenth resistors (R11-R16); the first input pin (A1) of the second isolation chip (U3) is electrically coupled to the enable pin (EN) of the GPIO interface (18) through the eleventh resistor (R11); the second input pin (A2) of the second isolation chip (U3) is electrically coupled to the first pulse width modulation pin (PWM1) of the GPIO interface (18) through the twelfth resistor (R12); the third input pin (A3) of the second isolation chip (U3) is electrically coupled to the second pulse width modulation pin (PWM2) of the GPIO interface (18) through the thirteenth resistor (R13); the first output pin (B1) of the second isolation chip (U3) is electrically coupled to the enable pin (EN) of the drive chip (28) through the fourteenth resistor (R14); the second output pin (B2) of the second isolation chip (U3) is electrically coupled to the first input pin (IN1) of the drive chip (28) through the fifteenth resistor (R15); and the third output pin (B3) of the second isolation chip (U3) is electrically coupled to the second input pin (IN2) of the drive chip (28) through the sixteenth resistor (R16).

20. The relay control circuit (100) of claim 1, wherein the control unit (12) comprises at least one of a central processing unit, a network processor, a digital signal processor, an application specific integrated circuit, a field-programmable gate array, and a micro control unit.
